# EUROPÄISCHE PATENTSCHRIFT

(11) **EP 3 242 400 B1**
(45) Veröffentlichungstag und Bekanntmachung des Hinweises auf die Patenterteilung: **13.05.2020**
(21) Anmeldenummer: 17176432.7
(22) Anmeldetag: 22.10.2013
(51) Int. Cl.: H03K 17/955, H03K 17/96

(54) **ELEKTRONISCHE SENSOREINHEIT ZUR ERFASSUNG EINER BERÜHRUNGSLOSEN BETÄTIGUNG EINER TÜR ODER KLAPPE AN EINEM KRAFTFAHRZEUG**
ELECTRONIC SENSOR UNIT FOR DETECTING A CONTACT-FREE ACTUATION OF A DOOR OR HATCH ON A MOTOR VEHICLE
UNITÉ DE DÉTECTION ÉLECTRONIQUE POUR L'ENREGISTREMENT D'UN ACTIONNEMENT SANS CONTACT D'UNE PORTE OU D'UN CLAPET SUR UN VÉHICULE AUTOMOBILE

(30) Priorität: 31.10.2012 DE 102012110436
(43) Veröffentlichungstag der Anmeldung: 08.11.2017
(62) Teilanmeldung aus: 13189641.7
(73) Patentinhaber: Huf Hülsbeck & Fürst GmbH & Co. KG, 42551 Velbert (DE)
(72) Erfinder: SIEG, Berthold, 46240 Bottrop (DE); SCHINDLER, Mirko, 42549 Velbert (DE); FRATTA, Stephan, 42855 Remscheid (DE); MONTAG, Patrick, 45219 Essen (DE); GERDES, Bernd, 45355 Essen (DE)
(74) Vertreter: Zenz Patentanwälte Partnerschaft mbB

(56) Entgegenhaltungen:
- EP-A2- 1 471 360

## Beschreibung

Die Erfindung betrifft eine elektronische Sensoreinheit zur Erfassung der berührungslosen Betätigung einer Tür oder Klappe an einem Kraftfahrzeug.

Die Sensoreinheit weist ein Gehäuse auf, in welchem eine Steuer- und Auswerteeinheit angeordnet ist. Eine Sensorelektrode ist mit der Steuer- und Auswerteeinheit gekoppelt, um eine Kapazitätsänderung der Sensorelektrode bei Betätigung durch einen Benutzer zu erfassen.

Kapazitive Sensoranordnungen mit Sensorelektroden, mit deren Hilfe das Eindringen eines Objekts in einen Raum vor der Sensorelektrode erfasst wird, sind im Stand der Technik bekannt.

Eine mit der Sensorelektrode gekoppelte Steuer- und Auswerteschaltung erfasst eine Änderung der Kapazität der Sensorelektrode gegenüber einem Referenzpotential, beispielsweise indem sie die Sensorelektrode mit einer vorgegebenen Frequenz periodisch auf- und entlädt und wenigstens einen Parameter eines vom periodischen Laden und Entladen der Sensorelektrode abhängigen Strom- oder Spannungsverlaufs zur Erfassung der Kapazitätsänderung auswertet. Die Sensorelektrode reagiert dabei auf Annäherungen bzw. Berührungen von Objekten durch eine Kapazitätsänderung des aus der Sensorelektrode und dem Objekt gebildeten Kondensators. Dies lässt sich im Kern darauf zurückführen, dass die Kapazität eines Kondensators von seinem Plattenabstand abhängt. Im Regelfall erhöht sich dessen Kapazität je näher das Objekt der Sensorelektrode kommt.

Eine kapazitive Sensoranordnung mit einer Sensorelektrode, mit deren Hilfe die Annäherung eines Objekts erfasst werden soll, ist beispielsweise aus dem US-Patent 5, 730, 165 bzw. der entsprechenden Patentschrift DE 196 81 725 B4 bekannt. Der Parameter eines vom periodischen Laden und Entladen der Sensorelektrode abhängigen Strom- oder Spannungsverlaufs ist dabei eine über einem Kondensator messbare Spannung, die von der auf dem Kondensator angesammelten Ladung abhängt, wobei diese Ladung dadurch angesammelt wird, dass periodisch wiederholt die Sensorelektrode durch Koppeln mit der Betriebsspannung aufgeladen und anschließend durch Koppeln mit dem Kondensator über diesen entladen wird. Ein anderer derartiger kapazitiver Sensor ist aus der Patentschrift EP 1 339 025 B1 bekannt. Ein anderes Beispiel einer kapazitiven Sensorelektrode ist aus der EP 1 471 360 A2 bekannt.

Bei kapazitiven Sensoren werden Kapazitätsänderungen auch als Variationen der Auflade- und/oder Entladezeit der Kapazität einer Sensorelektrode ermittelt. Beispielsweise arbeitet der Sensor nach dem Ladungstransferprinzip. Eine Auswerteelektronik nach dem Ladungstransferprinzip benötigt dabei wenigstens einen Referenzkondensator welcher turnusmäßig aufgeladen wird, wobei die Aufladezeit bestimmt wird und als Referenzzeitspanne für die Auswertung von Annäherungen oder Berührungen eines Objektes verwendet wird. Es werden also Änderungen der Aufladezeit des Referenzkondensators ausgewertet, die durch Annäherungen eines Objektes an die Sensorelektrode modifiziert werden.

Derartige Sensoranordnungen können verwendet werden, um eine Tür oder Klappe eines Kraftfahrzeugs, z.B. die Heckklappe zu betätigen. Dazu können Sensorelektroden verwendet werden, welche die Annäherung eines Körperteils, z.B. eine Schwenkbewegung eines Beines unter den Stoßfänger, detektieren und in ein Kommando zum Öffnen oder Schließen der Heckklappe an eine Steuereinrichtung im Kraftfahrzeug weiterleiten.

Ein Problem mit den bekannten Einrichtungen besteht darin, dass es aufwändig ist, die Steuerelektronik und die zugehörigen Elektroden zu montieren. Insbesondere kommt es zu häufig zu Fehlmontagen oder Fehlschaltungen der Anordnungen. Außerdem sind Sensoranordnungen an verschiedene Fahrzeugmodelle aufwändig anzupassen.

Aufgabe der Erfindung ist es daher, eine verlässliche Sensorik bereitzustellen, welche die Montage erleichtert und sicher zu kontaktieren ist.

Erfindungsgemäß wird diese Aufgabe durch eine Sensoranordnung mit den Merkmalen des Anspruchs 1 gelöst.

Erfindungsgemäß weist die elektronische Sensoreinheit eine Sensorelektrode auf. Es ist ein Steckverbinder an der Sensoreinheit vorgesehen, der Zuleitungen oder Kontaktleitungen zum Kabelbaum des Fahrzeuges aufweist und auch wenigstens eine flexible Sensorelektrode, so dass mittels desselben Steckverbinders sowohl die Sensorelektrode als auch der Kabelbaum mit der Steuer- und Auswerteschaltung koppelbar sind.

Gemäß diesem Aspekt der Erfindung wird also die Montage und Anordnung derart erleichtert, dass ein einziger Steckverbinder sowohl zur Verbindung der Sensoreinheit mit der übrigen Fahrzeugelektronik vorgesehen ist, als auch zum Anschluss der Sensorelektrode. Bei der Montage braucht nur ein einziger Stecker in eine Steckverbindung gesteckt zu werden, um beide Komponenten ordnungsgemäß mit der Sensoreinheit zu koppeln. Dies verringert die Gefahr von Steckervertauschungen und spart außerdem die Ausbildung mehrerer Steckverbinder ein, wie sie bisher nötig waren.

Die Sensorelektrode, die mit dem Steckverbinder kontaktiert ist, kann beliebig ausgeführt sein. Insbesondere kann ein Elektrodenkabel, beispielsweise ein Koaxkabel mit einer vorgegebenen Länge kontaktiert sein. Andererseits sind jedoch auch Folienelektroden möglich, die an dem Steckverbinder angeordnet sind.

In einer Weiterbildung dieser erfinderischen Lösung ist die Elektrode als Schlaufenelektrode oder Ringelektrode ausgebildet. Eine solche Schlaufenelektrode erlaubt einerseits die bessere Kontrolle der Elektrodenintegrität, indem eine Spannungsmessung oder Widerstandsmessung zwischen den Elektrodenenden durchführbar ist. Außerdem wird der von der Elektrode umgriffene Bereich wenigstens teilweise als sensitiver Bereich genutzt, da die Leiterschleife für die Detektion von Kapazitätsänderungen andere physikalische Eigenschaften hat als ein sich ausschließlich linear erstreckender Leiter.

Mit dem Steckverbinder, der sowohl die Sensorelektrode mit der Steuer- und Auswerteeinheit verbindet, als auch die übrige Fahrzeugelektronik anschließt, können auch mehrere Sensorelektroden gekoppelt sein. Wesentlich ist, dass über einen einzigen Steckverbinder sowohl Signalverbindungen zur Fahrzeugelektronik als auch Sensoranschlüsse für die kapazitiven Elektroden zur Verfügung gestellt werden.

Gemäß einer zweiten, nicht erfindungsgemäßen Variante weist die Sensoreinheit eine Sensorelektrode auf, die auf einen flexiblen Träger angeordnet ist. Die Sensorelektrode ist als elektrisch leitfähige Leiterstruktur auf dem Träger ausgebildet und zusammen mit dem flexiblen Träger verformbar.

Der flexible Träger sollte aus einem elektrisch isolierenden, beständigen Material gebildet sein. Insbesondere kommen Kunststoffmaterialien in Betracht. Die Sensorelektrode kann auf diesem Träger aufgeklebt sein, z.B. als Drahtanordnung oder metallische Folie. Der Träger schützt die Sensorelektrode vor übermäßigen Verformungen und vor zerstörender mechanischer Belastung. Der Träger erstreckt sich zusammen mit der Sensorelektrode wenigstens teilweise außerhalb des Gehäuses.

Gemäß der zweiten Variante ist demnach die Sensoreinheit so ausgebildet, dass ein flexibler Träger aus dem Gehäuse der Sensoreinheit hinausgeführt ist oder an dem Gehäuse angeordnet ist. Der flexible Träger ist zusammen mit der daran befestigten Sensorelektrode nach Anordnung der Sensoreinheit an ihren Bestimmungsort, z.B. im Bereich des Stoßfängers, an die Formgestaltung des Fahrzeuges anzupassen. Gehäuse und Träger mit Elektrode bilden also eine gemeinsame Baugruppe. Da es sich um einen flexiblen Träger handelt, kann der Träger mit der Elektrode beispielsweise auf der Innenseite des Stoßfängers angeordnet werden, um die kapazitive Erfassung auf der zugehörigen Außenseite des Stoßfängers zu ermöglichen. Die flexible Ausführung des Trägers und der Elektrode gestatten eine Anpassung an verschiedenste Bauformen und -größen von Kraftfahrzeugen, ohne dass für jedes Fahrzeug eine individuelle Sensorelektrode bereitgestellt werden muss.

Der Träger der Sensoreinheit kann hierfür eine geeignete Form annehmen, beispielsweise in Gestalt einer Zunge, eines Schlauches oder einer sonstigen Gestaltung. Die Elektrode ist in jeder Gestaltung so ausgebildet, dass sie zusammen mit dem Träger verformbar ist, z.B. auf der Innenseite des Schlauches oder einseitig auf einem dünnen Trägermaterial.

Die Elektrode kann auf dem Träger aufgeklebt sein oder aufgeschweißt oder aufgedampft. Es kann auch eine sonstige Art der Beschichtung oder Schichtstruktur ausgebildet werden.

Wesentlich ist, dass zu der Sensoreinheit eine Träger-Elektrodenstruktur mit flexibler Gestaltung kombiniert wird, um die Detektion für eine Vielzahl unterschiedlicher Kraftfahrzeuge zu ermöglichen.

In einer bevorzugten Ausgestaltung der zweiten Variante ist die Sensorelektrode als leitfähige Schichtstruktur auf dem Träger ausgebildet.

Während Drähte oder ähnliches auf dem Trägermaterial angeordnet und z.B. aufgeklebt werden können, ist die Ausbildung einer leitfähigen Schichtstruktur auf dem Träger besonders vorteilhaft. Die Schichtstruktur ermöglicht insbesondere bei dünnen Schichtdicken einen geringen Materialeinsatz, wobei gleichzeitig große Elektrodenflächen mit hoher Sensitivität auszubilden sind.

In einer bevorzugten Gestaltung wird außerdem die Sensorelektrode als ringförmiger Leiter auf dem Träger ausgebildet.

Die ringförmige Gestaltung einer Elektrode kann zu einer verbesserten Detektion führen und außerdem zu einer guten Detektierbarkeit von Elektrodenfehlern. Eine Ausführung als Ring kann sowohl bei der Montage als Gesteckt-Erkennung durch eine Spannungs- oder Widerstandsmessung zwischen dem Elektrodenenden verwendet werden als auch während des Betriebs für eine Überprüfung der Funktionsfähigkeit der Elektrode. Außerdem wird durch den von der Ringelektrode umgriffenen Raum eine verbesserte Detektionserfassung ermöglicht.

Es ist besonders bevorzugt, dass der flexible Träger als Flachmaterial, insbesondere als Folie ausgebildet ist.

Ein derartiger flacher Träger ist auf einfache Art und Weise auf der Innenseite eines Detektionsbereiches zu befestigen und weist außerdem eine gewisse mechanische Stabilität in Richtung seiner Erstreckungsebene auf. Während er in Richtungen senkrecht zu der flächigen Ebene biegbar und verformbar ist, ist die Verformbarkeit in Richtung der Fläche selbst eher gering. Dies reduziert weiterhin die Montagefehlermöglichkeiten, wenn die Steuereinrichtungen in einer vorgegebenen Stelle am Fahrzeug montiert werden. Es ist bei dieser Gestaltung dann kaum möglich, den Elektrodendetektionsbereich versetzt zu der Sensoreinheit anzuordnen, da sich die Elektrode bei Verformungen in dieser Richtung widersetzt.

In der bevorzugten Ausführungsform der zweiten Variante ist der Träger mit der Elektrode durch das Gehäuse der Sensoreinheit hindurchgeführt und im Inneren des Gehäuses kontaktiert, um mit der Steuer- und Auswerteeinheit gekoppelt zu werden. Die komplett innenliegende Kontaktierung der Elektrode verringert die Fehleranfälligkeit, insbesondere wenn das Gehäuse gegen Umwelteinflüsse verkapselt ist.

Zu diesem Zweck ist es besonders bevorzugt, wenn der Durchtrittsbereich des Trägers mit der Sensorelektrode in das Gehäuse gedichtet ausgeführt ist, insbesondere vergossen.

In einer Weiterbildung der zweiten Variante ist der Träger mit der Elektrode derartig als Schichtstruktur ausgebildet, dass die Deckseiten der Träger-Elektrodenanordnung aus einem elektrisch isolierenden Deckmaterial gebildet sind. Das eigentliche Elektrodenmaterial, die leitfähige Metallschicht beispielsweise, liegt zwischen zwei elektrisch isolierenden Deckseiten in Gestalt einer Sandwich-Struktur. Auf diese Weise sind Umwelteinflüsse oder auch der Kontakt des Trägers mit elektrisch leitenden Bauteilen ohne Einfluss auf die Detektion durch die Sensoreinheit.

Es ist für die Montage des Systems besonders sinnvoll, wenn der Träger mit einer Klebeschicht oder eine Klebevorrichtung versehen ist, um ihn bei der Montage im Bereich der Detektionszone klebend zu befestigen. Dazu kann beispielsweise eine Klebeschicht mit einer Deckfolie versehen sein, die nach Anordnung der Sensoreinheit am Einbauort abgezogen wird, um den Träger mit der Elektrode zu fixieren. Dies ist deutlich einfacher als die bisherige Anordnung von langgestreckten Sensorelektroden, beispielsweise gebildet aus Kabeln, die mit Kabelhaltern auf der Innenseite von Fahrzeugstoßfängern fixiert werden müssen.

Die Erfindung wird nun anhand der beiliegenden Zeichnungen näher erläutert.
Figur 1a zeigt in schematischer Weise die zweite Variante einer Sensoreinheit mit einer Folienelektrode;
Figur 1b zeigt die Variante aus Figur 1a in einer anderen Ansicht;
Figur 2a zeigt eine Ausführungsform der Erfindung mit Kontaktierung des Kabelbaumes und der Sensorelektrode über einen einzigen Steckverbinder;
Figur 2b zeigt die Ausführungsform aus Figur 2a in einer anderen Ansicht.

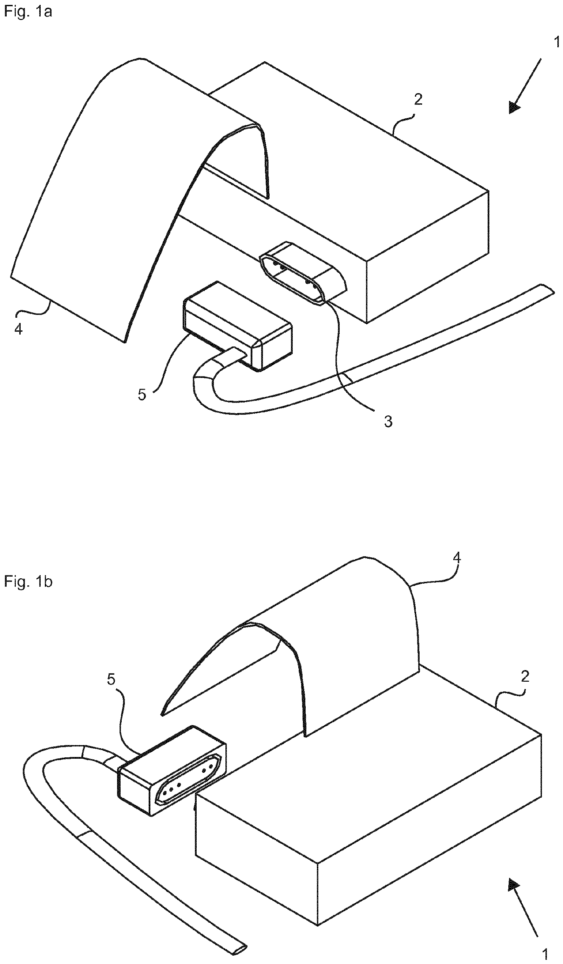

In Figur 1a ist eine nicht erfindungsgemäße zweite Variante der Sensoreinheit 1 gezeigt, die ein Gehäuse 2 und einen gehäuseseitigen Anschlussstecker 3 aufweist. In dem Gehäuse 2 ist eine Steuer- und Auswerteeinrichtung aufgenommen (nicht gezeigt), welche mit den Kontakten des Anschlusssteckers 3 gekoppelt ist. Ein flexibler Träger 4 ist mit einer Elektroden-Schichtstruktur versehen. Die Elektrode ist flächig als metallische Schicht auf dem Träger derart aufgebracht, dass der Träger 4 eine Grundschicht aus einem Kunststoff-Material, eine Zwischenschicht aus einem elektrisch leitfähigen Material und eine Deckschicht aus demselben Kunststoffmaterial aufweist. So sind die außenliegenden Bereiche des Trägers 4 elektrisch isolierend und umschließen die Sensorelektrode.

Dieser Träger-Elektrodenstreifen 4 ist durch eine Schlitzöffnung im Gehäuse 2 in das Gehäuse hineingeführt. Im Inneren des Gehäuses ist die Elektrodenschicht mit der Steuer- und Sensoreinheit elektrisch gekoppelt, um die Sensorelektrode 4 kapazitiv auszuwerten. Diese kapazitive Auswertung geschieht in derselben Form, wie bei den bisher bekannten und oben stehenden erläuterten kapazitiven Sensorsystemen. Dadurch, dass die Sensorelektrode 4 im Inneren des Gehäuses 2 kontaktiert ist, wobei die Träger-Elektrodenkombination zu diesem Zweck z.B. durchstoßen ist, um die innenliegende Elektrodenschicht zu kontaktieren, ist der Außenbereich der Elektrode geschützt. Der Durchtrittsbereich der Elektrode 4 durch das Gehäuse 2 ist mit einem flexiblen Kunststoffmaterial umgossen. Ein Steckverbinder 5 verbindet das Steuergerät mit dem Kabelbaum eines Fahrzeuges.

Es ist ersichtlich, dass die Ausbildung dieser Sensoreinheit den Vorteil bringt, dass die Sensoreinheit an einer geeigneten Stelle im Fahrzeug zu platzieren ist, beispielsweise auf der Innenseite eines Stoßfängers. Die flexible Elektrode 4 weist eine Klebeschicht auf oder wird mit einem Klebeelement versehen und nach Anordnung des Gehäuses an der Zielposition beispielsweise auf die Innenseite des Stoßfängers geklebt, um in unmittelbarer Anlage an den Stoßfänger sensitiv für Kapazitätsänderungen zu sein, die durch einen sich annähernden Benutzer hervorgerufen werden. Da die Sensorelektrode 4 flexibel und verformbar ist, können sowohl geringe Montageungenauigkeiten als auch die Strukturen unterschiedlicher Fahrzeuge ausgeglichen werden. Es ist außerdem möglich, für unterschiedliche Fahrzeugtypen unterschiedlich ausgeformte Elektrodenstreifen 4 vorzusehen. Auch gänzlich andere Gestaltungen der Elektrode 4 sind möglich, beispielsweise gefächerte Ausführungen des Trägers und der Elektrodenstruktur oder aber ringförmige Gestaltungen. Auch mehrere Träger und zugehörige Elektroden können problemlos auf diese Weise ausgebildet werden. Es ist außerdem möglich, die flexible Elektrode 4 mit einer Elektroden-Schichtstruktur zu versehen, so dass beispielswiese hintereinander die bei anderen kapazitiven Sensorelektroden verwendeten Elektrodenabfolgen aus Sensorelektrode und Schild-Elektrode verwendet werden können.

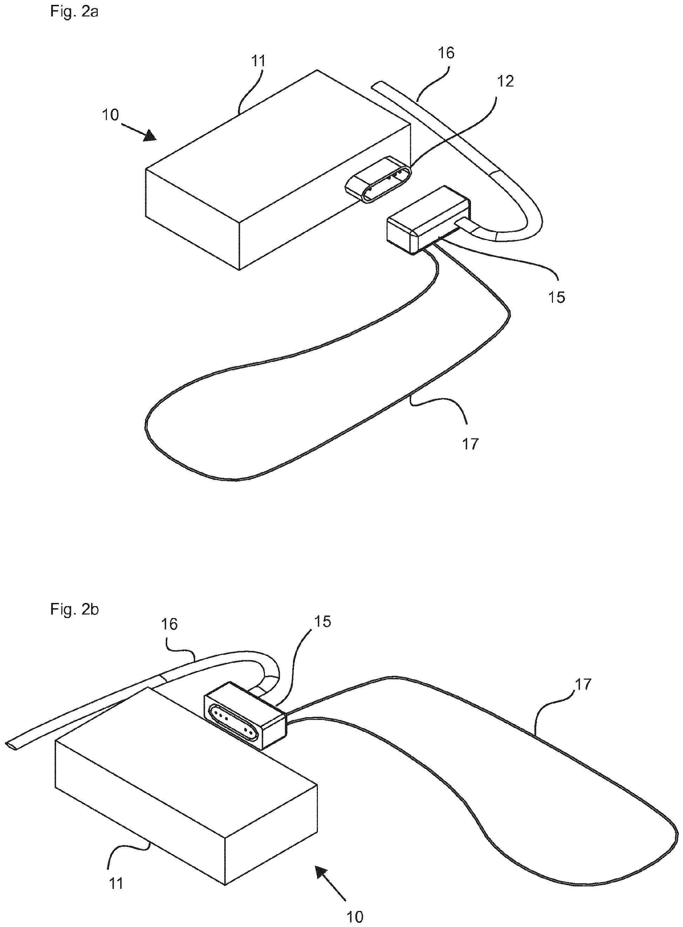

Die Figuren 2a und 2b zeigen eine erfindungsgemäße Sensoranordnung 10 mit einem Gehäuse 11 welches einen Anschlussstecker 12 aufweist, der wiederum mit der im Gehäuse 11 angeordneten Steuer- und Auswerteeinheit verbunden ist. In dieser Ausführungsform ist ein Steckverbinder 15 vorgesehen, der ein Leitungsbündel 16 zur Versorgung und Steuerung oder auch Abfrage der Sensoreinheit aufweist. Über das Leitungsbündel 16 ist die Sensoreinheit 10 mit dem Kabelbaum des Fahrzeuges gekoppelt. Über denselben Steckverbinder 15 ist eine Sensorelektrodenschlaufe 17 mit dem Anschluss 12 koppelbar. Das erfinderische System oder die erfinderische Sensoreinheit bestehen daher sowohl aus der Gehäuseeinheit 11 als auch aus dem speziell ausgebildeten Steckverbinder 15, der die Sensorelektrode und das Anschlusspaket zum Kabelbaum mitbringt. In dieser Gestaltung ist die Sensorelektrode 17 als isolierend ummantelndes Kabel ausgebildet, welches ringförmig verläuft und am Stecker zwei Anschlüsse aufweist. Auf diese Weise kann das Steuergerät im Gehäuse 11 unmittelbar nach Anschluss prüfen, ob die Sensorelektrodenschlaufe ordnungsgemäß kontaktiert ist, was beispielsweise über eine Widerstands- oder Spannungsmessung erfolgen kann. Die Montage dieses Systems wird deutlich erleichtert, da eine einzige Steckverbindung in vertauschungssicherer Weise herzustellen ist, wobei gleichzeitig die Sensorelektrode und auch der Anschluss an den Kabelbaum des Fahrzeuges hergestellt wird.

Im Rahmen der Ausgestaltung dieser Erfindung kann die Elektrodenanordnung selbstverständlich variiert werden, beispielsweise können mehrere Elektroden mit dem Stecker 15 gekoppelt sein, die gleichzeitig mit der Einrichtung verbunden werden.

## Patentansprüche

1. Elektronische Sensoreinheit (10) zur Erfassung der berührungslosen Betätigung einer Tür oder Klappe an einem Kraftfahrzeug, wobei die Sensoreinheit (10) ein Gehäuse (11) aufweist, in welchem eine Steuer- und Auswerteeinheit angeordnet ist und wobei eine Sensorelektrode (17) mit der Steuer- und Auswerteeinheit gekoppelt ist, um eine Kapazitätsänderung der Sensorelektrode (17) bei Betätigung durch einen Benutzer zu erfassen,
wobei an dem Gehäuse ein Anschlussstecker (12) mit Kontakten angeordnet ist, um die Sensoreinheit (10) und die darin angeordnete Steuer- und Auswerteeinheit mit einem Kabelbaum eines Fahrzeuges zu verbinden,
**dadurch gekennzeichnet,**
**dass** die Sensoreinheit (10) einen mit dem Anschlussstecker (12) koppelbaren Steckverbinder (15) aufweist, welcher sowohl Zuleitungen (16) zur Verbindung der Sensoreinheit mit dem Kabelbaum aufweist, als auch die als flexible Sensorelektrode (17) ausgebildete Sensorelektrode (17), so dass mittels desselben Steckverbinders sowohl die Sensorelektrode (17) als auch der Kabelbaum mit der Steuer- und Auswerteschaltung koppelbar sind.

2. Sensoreinheit nach Anspruch 1, wobei an dem Steckverbinder (15) eine Schlaufenelektrode (17) ausgebildet ist, welche über den Steckverbinder (15) mit der Steuer- und Auswerteeinrichtung kontaktierbar ist.

3. Sensoreinheit nach Anspruch 1 oder 2, wobei der Steckverbinder (15) mehrere Sensorelektroden aufweist.

## Claims

1. Electronic sensor unit (10) for detecting the contact-free actuation of a door or hatch on a motor vehicle, wherein the sensor unit (10) has a housing (11) in which a control and evaluation unit is arranged and wherein a sensor electrode (17) is coupled to the control and evaluation unit in order to detect a capacitance change of the sensor electrode (17) on actuation by a user,
wherein a connection socket (12) with contacts is arranged on the housing in order to connect the sensor unit (10) and the control and evaluation unit arranged therein to a cable harness of a vehicle,
**characterized in that**
the sensor unit (10) has a plug connector (15), which can be coupled with the connection socket (12) and which comprises both supply cables (16) for connecting the sensor unit to the cable harness as well as the flexible sensor electrode (17), which is implemented as a flexible sensor electrode (17), so that both the sensor electrode (17) and the cable harness can be coupled to the control and evaluation unit by means of the same plug connector.

2. Sensor unit according to Claim 1, wherein on the plug connector (15) a loop electrode (17) is formed, which can be contacted with the control and evaluation unit via the plug connector (15).

3. Sensor unit according to Claim 1 or 2, wherein the plug connector (15) has a plurality of sensor electrodes.

## Revendications

1. Unité de détection électronique (10) pour détecter l'actionnement sans contact d'une porte ou d'un clapet sur un véhicule automobile, dans lequel l'unité de détection (10) présente un boîtier (11), dans lequel une unité de commande et d'évaluation est disposée et dans lequel une électrode de détection (17) est couplée avec l'unité de contrôle et d'évaluation, afin de détecter le changement de capacité de l'électrode de détection (17) lorsqu'elle est actionnée par un utilisateur,
dans lequel un connecteur (12) avec des contacts est disposé sur le boîtier, afin de connecter l'unité de détection (10) et l'unité de commande et d'évaluation disposée à l'intérieur avec un faisceau de câbles d'un véhicule,
**caractérisé en ce que**
l'unité de détection (10) présente un connecteur enfichable (15) pouvant être couplé avec le connecteur (12), qui présente tant des lignes d'alimentation (16) pour connecter l'unité de détection au faisceau de câbles, que l'électrode de détection (17) configurée comme une électrode de détection flexible (17), de sorte que tant l'électrode de détection (17) que le faisceau de câbles puissent être couplés au circuit de commande et d'évaluation au moyen du même connecteur.

2. Unité de détection selon la revendication 1, dans laquelle sur le connecteur enfichable (15) une électrode en boucle (17) est réalisée, qui peut être contactée par l'intermédiaire du connecteur enfichable (15) avec le dispositif de commande et d'évaluation.

3. Unité de détection selon la revendication 1 ou 2, dans laquelle le connecteur enfichable (15) présente une pluralité d'électrodes de détection.
